# EUROPEAN PATENT APPLICATION

(11) **EP 2 854 165 A1**
(43) Date of publication of application: **01.04.2015**
(21) Application number: 14187008.9
(22) Date of filing: 30.09.2014
(51) Int. Cl.: H01L 21/67

(54) **Substrate processing device and substrate processing method**

(30) Priority: 30.09.2013 JP 2013205126; 04.07.2014 JP 2014139197
(71) Applicant: Shibaura Mechatronics Corporation, Yokohama-shi Kanagawa (JP)
(72) Inventor: NAGASHIMA, Yuji, Kanagawa (JP); MATSUSHITA, Jun, Kanagawa (JP); SAITO, Yuki, Kanagawa (JP); HAYASHI, Konosuke, Kanagawa (JP); MIYAZAKI, Kunihiro, Kanagawa (JP)
(74) Representative: Twelmeier Mommer & Partner

(57) **Abstract**

In a substrate processing device 10, a magnetic field forming unit is added to a solvent supply unit 58. The magnetic field forming unit 100 applies a magnetic field to a surface of a substrate W on which a cleaning liquid and a volatile solvent coexist. The magnetic field forming unit stirs and mixes the cleaning liquid and the volatile solvent on the surface of the substrate W to promote replacement of the cleaning liquid with the volatile solvent.

## Description

The disclosure of Japanese Patent Application No. 2013-205126 filed September 30, 2013 and Japanese Patent Application No. 2014-139197 filed July 4, 2014 including specifications, drawings and claims is incorporated herein by reference in its entirety.

### [Field of the Invention]

The present intention relates to a substrate processing device and a substrate processing method.

### [Related Art]

In manufacturing semiconductors and others, a substrate processing device supplies a processing liquid to a surface of a substrate of a wafer, a liquid crystal substrate or the like to process a surface of the substrate, then supplies a cleaning liquid such as ultrapure water to the substrate surface to clean the substrate surface, and further dries it. In the drying, there are problems that occur with patterns, e.g., around memory cells and gates collapses due to miniaturization according to increase in integration degree and capacity of the semiconductors in recent years. This is due to spacing between patterns, structures of them, a surface tension of the cleaning liquid and others. During the substrate drying, since the patterns are mutually pulled by a surface tension of a cleaning liquid that remains between the patterns, the patterns elastically deform and fall so that the pattern collapse occurs.

Accordingly, for the purpose of suppressing the pattern collapsing, such a substrate drying method has been proposed (e.g., see JP 2008-34779 A (Patent Literature 1)) that uses IPA (2-Propanol: Isopropyl Alcohol) having a smaller surface tension than the ultrapure water, and mass production factories and others have employed a method of drying the substrate by replacing the ultrapure water on the substrate surface with the IPA.

[Patent Literature 1] Japanese Patent Application Publication No. 2008-34779

### [Summary of the Invention]

### [Problems to be Solved by the Invention]

In the prior art, however, the cleaning liquid supplied to the surface of the substrate cannot be sufficiently replaced with the volatile solvent such as IPA without difficulty, and the pattern collapse during the substrate drying cannot be effectively prevented. This pattern collapse becomes more remarkable as the semiconductors are miniaturized to a further extent.

An object of the invention is to prevent effectively the pattern collapse during the substrate drying by reliably replacing the cleaning liquid on the substrate surface with the volatile solvent.

### [Means for Solving the Problems]

A substrate processing device according to the invention includes:
a cleaning liquid supply unit supplying a cleaning liquid to a surface of a substrate;
a solvent supply unit supplying a volatile solvent to the surface of the substrate supplied with the cleaning liquid, and replacing the cleaning liquid on the surface of the substrate with the volatile solvent; and
a heating and drying unit heating the surface of the substrate supplied with the volatile solvent to dry the surface of the substrate by removing droplets of the volatile solvent produced on the surface of the substrate by a heating operation, wherein
the substrate processing device further includes a magnetic field forming unit applying a magnetic field to the surface of the substrate on which the cleaning liquid and the volatile solvent coexist to promote the replacement of the cleaning liquid with the volatile solvent.

A substrate processing method according to the invention includes the steps of:
supplying a cleaning liquid to a surface of a substrate;
supplying a volatile solvent to the surface of the substrate supplied with the cleaning liquid, and replacing the cleaning liquid on the surface of the substrate with the volatile solvent; and
heating the surface of the substrate supplied with the volatile solvent to dry the surface of the substrate by removing droplets of the volatile solvent produced on the surface of the substrate by a heating operation, wherein
a magnetic field is applied by a magnetic field forming unit to the surface of the substrate on which the cleaning liquid and the volatile solvent coexist to promote the replacement of the cleaning liquid with the volatile solvent.

### [Effect of the Invention]

The substrate processing device and the substrate processing method according to the invention can reliably replace the cleaning liquid on the substrate surface with the volatile solvent, and thereby can effectively prevent the pattern collapse during the substrate drying.

### [BRIEF DESCRIPTION OF DRAWINGS]

FIG. 1 is a schematic view of a substrate processing device;
FIG. 2 is a schematic view illustrating a structure of a substrate cleaning chamber in the substrate processing device;
FIGS. 3A to 3C are schematic views illustrating magnets forming a magnetic field forming unit;
FIGS. 4A to 4D are schematic views illustrating a state of replacement of a cleaning liquid on a substrate surface;
FIG. 5 is a schematic view illustrating a structure of a substrate drying chamber in the substrate processing device;
FIG. 6 is a schematic view illustrating a structure of a transporting unit in the substrate processing device;
FIG. 7 is a schematic view illustrating a modification of the substrate cleaning chamber;
FIG. 8A and 8B are schematic views illustrating magnets forming a magnetic field forming unit;
FIGS. 9A and 9B are schematic views illustrating a state of drying of a volatile solvent on the substrate surface; and
FIG. 10 is a schematic view illustrating a Moses effect.

### [DETAILED DESCRIPTION]

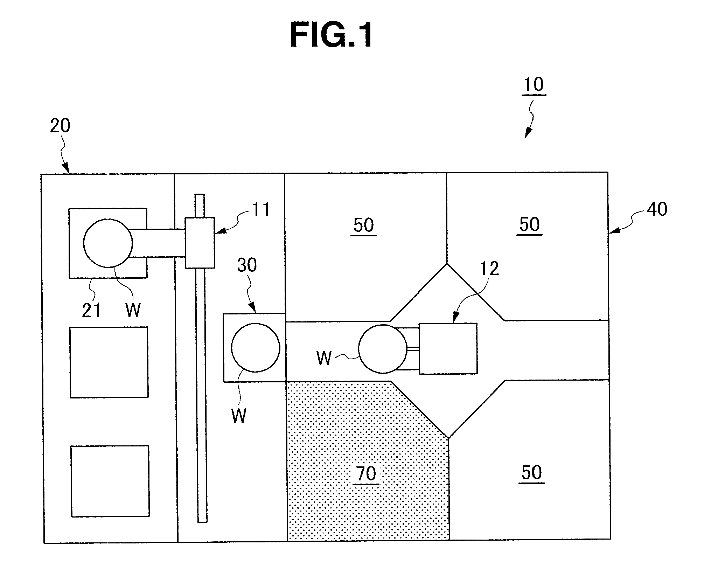

A substrate processing device 10 includes, as illustrated in FIG. 1, a substrate supply/discharge unit 20, a substrate storing buffer unit 30, and a plurality of substrate processing chambers 40. A transporting robot 11 is arranged between the substrate supply/discharge unit 20 and the substrate storing buffer unit 30, and a transporting robot 12 is arranged between the substrate storing buffer unit 30 and the substrate processing chamber 40. The substrate processing chamber 40 is formed of a set of a substrate cleaning chamber(s) 50 and a substrate drying chamber(s) 70, as will be described later.

The substrate supply/discharge unit 20 can transfer a plurality of substrate storing cassettes 21 therefor and thereto. The substrate storing cassette 21 stores a plurality of substrates W such as unprocessed wafers, liquid crystal substrates and the like, and is transferred into the substrate supply/discharge unit 20. The substrate storing cassette 21 stores the substrates W processed in the substrate processing chamber 40, and is transferred from the substrate supply/discharge unit 20. The unprocessed substrates W are successively taken out by the transporting robot 11 from multi-level storage shelves of the substrate storing cassette 21 in the substrate supply/discharge unit 20, and are supplied to an in-dedicated buffer 31 (to be described later) of the substrate storing buffer unit 30. The unprocessed substrate W supplied to the in-dedicated buffer 31 is further taken out by the transporting robot 12, and is supplied to the substrate cleaning chamber 50 of the substrate processing chamber 40 for the cleaning processing. The substrate W cleaned in the substrate cleaning chamber 50 is moved by the transporting robot 12 from the substrate cleaning chamber 50 to the substrate drying chamber 70, and is subjected to drying processing. The transporting robot 12 takes out the substrate W thus processed from the substrate drying chamber 70, and puts it into an out-dedicated buffer 32 (to be described later) of the substrate storing buffer unit 30 for temporary storage. The transporting robot 11 takes out the substrates W temporarily stored in the out-dedicated buffer 32 of the substrate storing buffer unit 30, and successively discharges them onto empty shelves in the substrate storing cassette 21 of the substrate supply/discharge unit 20. The substrate storing cassette 21 filled with the processed substrates W is discharged from the substrate supply/discharge unit 20.

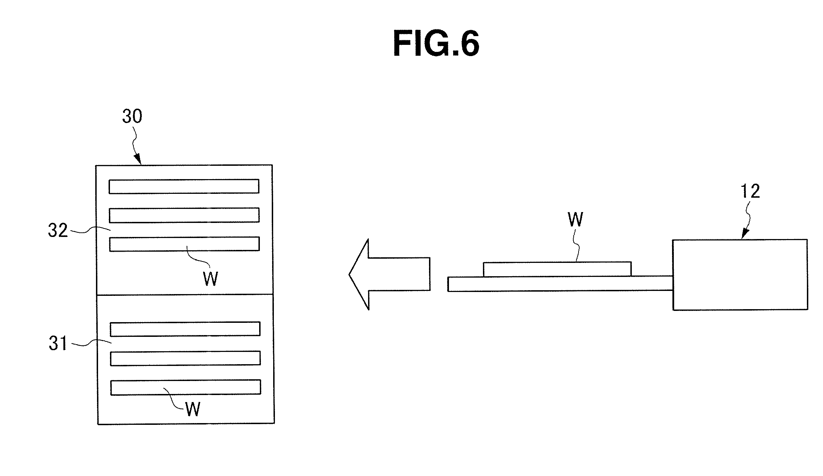

The substrate storing buffer unit 30 is provided, as illustrated in FIG. 6, with the plurality of in-dedicated buffers 31 taking the form of multi-level shelves for storing the unprocessed substrates W as well as the plurality of out-dedicated buffers 32 taking the form of multi-level shelves for storing the substrates W subjected to the cleaning and drying processing in the substrate processing chamber 40. A cooling unit for cooling the temporarily stored substrates W may be arranged in the out-dedicated buffer 32. The in-dedicated buffer 31 and/or the out-dedicated buffer 32 may have structures other than the multi-level shelves.

The substrate processing chamber 40 has a set of the substrate cleaning chamber 50 and the substrate drying chamber 70 located around (or on the opposite sides of) the transporting robot 12 positioned in a travel end remote from the substrate storing buffer unit 30 and close to the substrate processing chamber 40, and is configured to move the substrate W cleaned in the substrate cleaning chamber 50 to the substrate drying chamber 70 in the same set for drying it. The substrate processing chamber 40 is configured such that numbers i and j of the substrate cleaning chambers 50 and the substrate drying chambers 70 in the same set satisfy the relationship of (i : j = N : 1) where N is the cleaning operation time in the substrate cleaning chamber 50 when the drying operation time in the substrate drying chamber 70 is 1. Thereby, when all the substrate cleaning chamber(s) 50 and the substrate drying chamber(s) 70 forming the one set in the substrate processing chamber 40 operate in parallel within the same time period, a production quantity of the substrate cleaning chamber(s) 50 cleaning the substrates W can be substantially equal to a production quality of the substrate drying chamber(s) 70 drying the preceding substrates W already cleaned in the substrate cleaning chambers 50.

In each of the multiple levels (e.g., three levels) of the substrate processing chamber 40 of the embodiment, the substrate cleaning chambers 50 and the substrate drying chamber 70 forming the one set are arranged, and the drying operation time of the substrate drying chamber 70 is 1 when the cleaning operation time N of the substrate cleaning chamber 50 is 3 (N = 3). Therefore, the substrate processing chamber 40 of the embodiment is provided at each level with the substrate cleaning chambers 50 of i = 3 in number and the substrate drying chamber 70 of j = 1 in number.

The substrate cleaning chamber 50 and the substrate drying chamber 70 forming the substrate processing chamber 40 will be described below in detail.

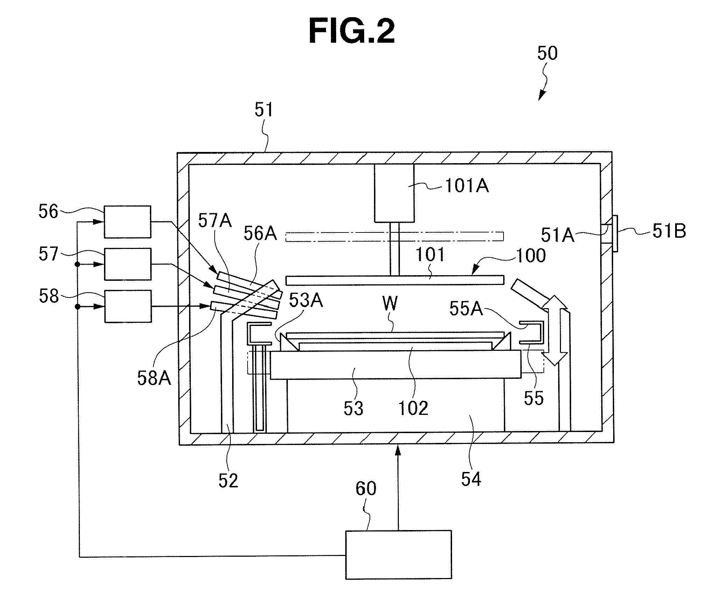

The substrate cleaning chamber 50 includes, as illustrated in FIG. 2, a processing box 51 forming a processing chamber, a cup 52 arranged in the processing box 51, a table 53 horizontally carrying the substrate W in the cup 52, a rotation mechanism 54 rotating the table 53 in a horizontal plane, and a solvent suction discharging unit 55 that is vertically movable around the table 53. Further, the substrate cleaning chamber 50 includes a chemical solution supply unit 56 supplying a chemical solution to a surface of the substrate W on the table 53, a cleaning liquid supply unit 57 supplying a cleaning liquid to a surface of the substrate W on the table 53, a solvent supply unit 58 supplying a volatile solvent, and a controller 60 controlling the various portions.

The processing box 51 has a substrate inlet/outlet opening 51A opening at a portion of its peripheral wall. A shutter 51B can close and open the substrate inlet/outlet opening 51A.

The cup 52 has a cylindrical form, surrounds the periphery of the table 53, and accommodates it. The cup 52 has a peripheral wall having an upper portion tapered to converge upward, and has an opening to expose the substrate W on the table 53 upward. This cup 52 receives the chemical solution and cleaning liquid that flow or disperse from the rotating substrate W. The cup 52 is provided at its bottom with a discharge pipe (not illustrated) for discharging the received chemical solution and cleaning liquid.

The table 53 is positioned near a center of the cup 52, and is rotatable in the horizontal plane. The table 53 has a plurality of support members 53A such as pins, which removably hold the substrate W such as a wafer or a liquid crystal substrate.

The rotation mechanism 54 has a rotation shaft coupled to the table 53, a motor serving as a drive source for rotating the rotation shaft, and others (not illustrated), and rotates the table 53 by the driving of the motor through the rotation shaft. The rotation mechanism 54 is electrically connected to the controller 60, which controls the drive of the rotation mechanism 54.

The solvent suction discharging unit 55 includes a solvent absorbing port 55A having an annular opening surrounding the periphery of the table 53. The solvent suction discharging unit 55 has an elevator mechanism (not illustrated) for vertically moving the solvent absorbing port 55A, and vertically moves the solvent absorbing port 55A between a standby position where the solvent absorbing port 55A is positioned lower than the table surface of the table 53 and an operation position where the solvent absorbing port 55A is positioned around the substrate W held by the table 53. The solvent absorbing port 55A absorbs and receives the volatile solvent dispersed from the rotating substrate W. The solvent absorbing port 55A is connected to an exhaust fan or a vacuum pump (not illustrated) for absorbing the volatile solvent as well as an exhaust pipe (not illustrated) for discharging the volatile solvent that is absorbed and received.

The chemical solution supply unit 56 has a nozzle 56A discharging the chemical solution obliquely to the surface of the substrate W on the table 53, and supplies the chemical solution such as APM (Ammonia and hydrogen Peroxide Mixture) for organic substance removing to the surface of the substrate W on the table 53 through the nozzle 56A. The nozzle 56A is attached to an upper portion of the peripheral wall of the cup 52, and its angle, discharging flow velocity and others are adjusted to supply the chemical solution to the vicinity of the surface center of the substrate W. The chemical solution supply unit 56 is electrically connected to the controller 60, which controls the drive of the chemical solution supply unit 56. The chemical solution supply unit 56 includes a tank storing the chemical solution, a pump serving as a drive source, a valve serving as a regulator valve regulating a supply rate, and others, although not illustrated.

The cleaning liquid supply unit 57 has a nozzle 57A discharging the cleaning liquid obliquely to the surface of the substrate W on the table 53, and supplies the cleaning liquid such as pure water (ultrapure water) for cleaning processing to the surface of the substrate W on the table 53 through the nozzle 57A. The cleaning liquid supplied from the cleaning liquid supply unit 57 may be functional water of, for example, ozone. The nozzle 57A is attached to the upper portion of the peripheral wall of the cup 52, and its angle, discharging flow velocity and others are adjusted to supply the cleaning liquid to the vicinity of the surface center of the substrate W. The cleaning liquid supply unit 57 is electrically connected to the controller 60, which controls the drive of the cleaning liquid supply unit 57. The cleaning liquid supply unit 57 includes a tank storing the cleaning liquid, a pump serving as a drive source, and a valve serving as a regulator valve regulating a supply rate, although not illustrated.

The solvent supply unit 58 has a nozzle 58A discharging the volatile solvent obliquely to the surface of the substrate W on the table 53, and supplies the volatile solvent such as IPA to the surface of the substrate W on the table 53 through the nozzle 58A. The solvent supply unit 58 supplies the volatile solvent to the surface of the substrate W cleaned with the cleaning liquid supplied by the cleaning liquid supply unit 57, and replaces the cleaning liquid on the surface of the substrate W with the volatile solvent. The nozzle 58A is attached to the upper portion of the peripheral wall of the cup 52, and its angle, discharging flow velocity and others are adjusted to supply the volatile solvent to the vicinity of the surface center of the substrate W. The solvent supply unit 58 is electrically connected to the controller 60, which controls the drive of the solvent supply unit 58. The solvent supply unit 58 includes a tank storing the volatile solvent, a pump serving as a drive source, and a valve serving as a regulator valve regulating a supply rate, although not illustrated.

In addition to the IPA, monovalent alcohols such as ethanol, and ethers such as diethyl ether and ethyl methyl ether as well as ethylene carbonate and the like may be used as the volatile solvent. The volatile solvent is preferably water-soluble.

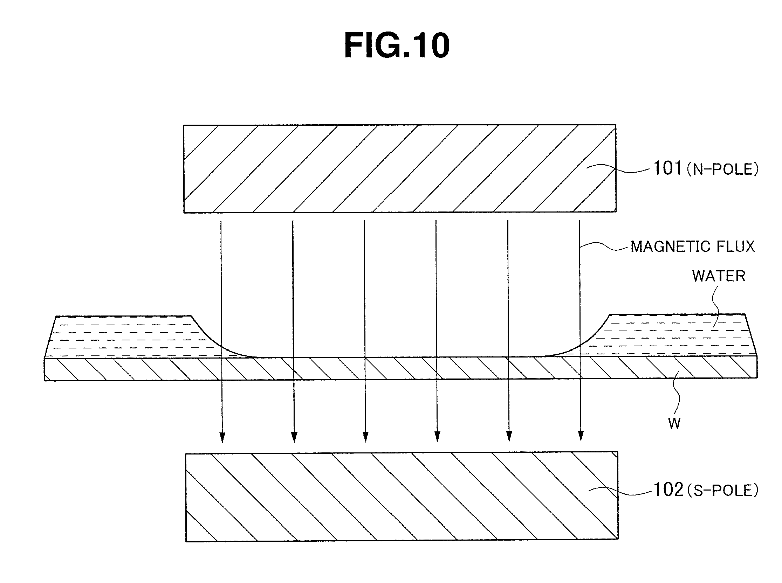

A magnetic field forming unit 100 is added to the solvent supply unit 58. The magnetic field forming unit 100 applies a magnetic field to a surface of the substrate W on which the cleaning liquid supplied from the cleaning liquid supply unit 57 and the volatile solvent supplied from the solvent supply unit 58 coexist. Using a Moses effect of this magnetic field, the magnetic field forming unit 100 stirs and mixes the cleaning liquid and the volatile solvent on the surface of the substrate W to promote replacement of the cleaning liquid with the volatile solvent. The Moses effect is a phenomenon in which, when strong magnetic flux produced between an upper magnet 101 (N-pole) and a lower magnet 102 (S-pole) is applied to water on the surface of the substrate W, as illustrated in FIG. 10, the water escapes from a position of a strong magnetic field to a position of a weak magnetic field because the water is a diamagnetic substance, so that a water surface is concaved. In FIG. 10, the upper magnet 101 may be the S-pole, and the lower magnet 102 may be the N-pole.

The magnetic field forming unit 100 is formed of a pair of the upper and lower magnets 101 and 102 which are arranged on the front and rear sides of the substrate W held on the table 53, respectively.

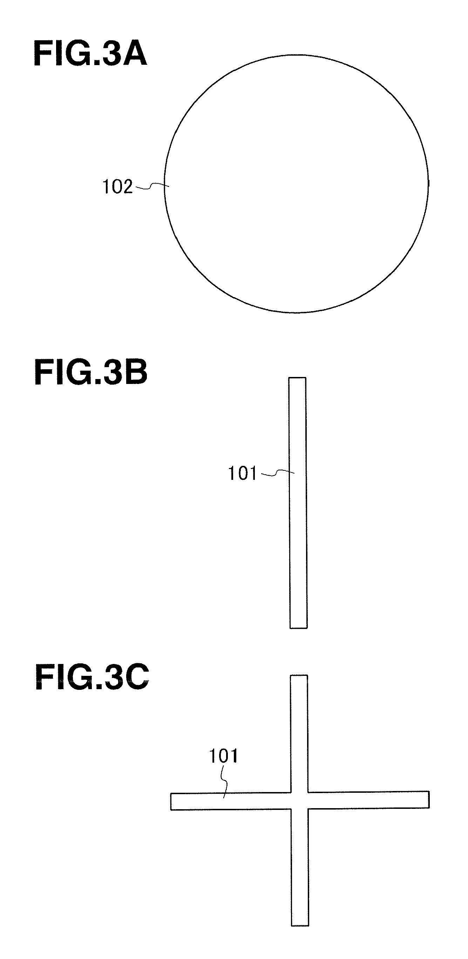

As illustrated in FIGS. 2 and 3, the upper magnet 101 has a form of a single rod (FIG. 3B) or a cross-shaped rod (FIG. 3C) which is vertically movably hung from an elevating unit 101A arranged on a ceiling surface of the processing box 51. The upper magnet 101 can be raised and lowered to occupy selectively a standby position (indicated by alternate long and short dash line in FIG. 2) spaced from the surface of the substrate W and an operation position (indicated by solid line in FIG. 2) close to the surface of the substrate W.

The lower magnet 102 is fixed, as illustrated in FIGS. 2 and 3A, to the upper surface of the table 53, and has a circular disk-like form rotating together with the table 53.

By locating the upper magnet 101 in the operation position, the magnetic field forming unit 100 enhances the magnetic field by increasing density of the magnetic flux occurring between the upper and lower magnets 101 and 102, and thereby increases the stirring and mixing efficiency for the cleaning liquid and the volatile solvent on the surface of the substrate W. Specifically, when the substrate W is set on the table 53 and is positioned in the magnetic field between the upper and lower magnets 101 and 102, the Moses effect concaves the surface of the water which is present in the region on the substrate W opposed to the upper magnet 101 and is located between the patterns on the surface of the substrate W. At this time, in the region of the substrate W not opposed to the upper magnet 101, the water between the patterns on the surface of the substrate W is not subjected to the Moses effect, and therefore does not receive a force of concaving the water surface. Accordingly, by rotating the substrate W together with the table 53, the water between the patterns on the surface of the rotating substrate W intermittently receives the force caused by the magnetic field. Therefore, the variations in such force oscillate and stir the water between the patters, so that the water is mixed with the volatile solvent.

The controller 60 includes a microcomputer that centrally controls the various portions, and a storage storing substrate processing information relating to the substrate processing, various kinds of programs and others. The controller 60 controls, based on the substrate processing information and various programs, the rotation mechanism 54, solvent suction discharging unit 55, chemical solution supply unit 56, cleaning liquid supply unit 57, solvent supply unit 58, magnetic field forming unit 100 and others, and controls the supplying of the chemical solution by the chemical solution supply unit 56, supplying of the cleaning liquid by the cleaning liquid supply unit 57, supplying of the volatile solvent by the solvent supply unit 58 performed on the surface of the substrate W on the rotating table 53, and others.

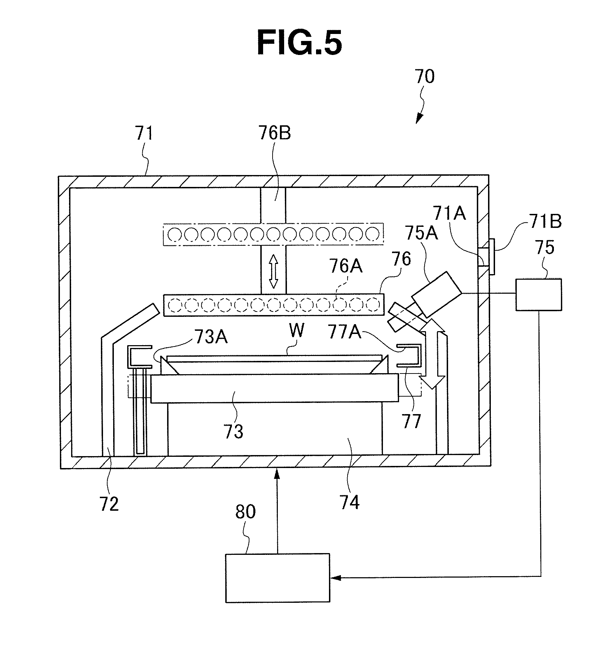

The substrate drying chamber 70 includes, as illustrated in FIG. 5, a processing box 71 serving as a processing chamber, a cup 72 arranged in the processing box 71, a table 73 horizontally carrying the substrate W in the cup 72, a rotation mechanism 74 rotating the table 73 in a horizontal plane, a gas supply unit 75 supplying a gas, a heating unit 76 heating the surface of the substrate W supplied with the volatile solvent, a suction drying unit 77 for drying the surface of the substrate W heated by the heating unit 76, and a controller 80 controlling various portions and units.

The processing box 71, the cup 72, the table 73, and the rotation mechanism 74 are similar to the processing box 51, the cup 52, the table 53, and the rotation mechanism 54 in the substrate cleaning chamber 50, respectively. In FIG. 5, 71A indicates a substrate inlet/outlet opening, 71B indicates a shutter, and 73A indicates a support member such as a pin.

The gas supply unit 75 has a nozzle 75A discharging a gas obliquely to the surface of the substrate W on the table 73. The nozzle 75A supplies a gas such as a nitrogen gas to the surface of the substrate W on the table 73 to provide a nitrogen gas atmosphere in a space on the surface of the substrate W in the processing box 71. The nozzle 75A is attached to an upper portion of a peripheral wall of the cup 72, and an angle, a discharging flow velocity and others of the nozzle 75A are adjusted to supply the gas to vicinity of the surface center of the substrate W. This gas supply unit 75 is electrically connected to the controller 80, which controls the driving thereof. The gas supply unit 75 includes a tank storing the gas, a valve operating as a regulating valve for regulating the supply rate, and others, although these are not illustrated.

As the supplied gas, an inert gas such as argon gas, carbon dioxide gas or helium gas other than nitrogen gas can be used. Since the inert gas is supplied to the surface of the substrate W, the oxygen on the surface of the substrate W can be removed, and production of watermarks can be prevented. Gas to be supplied is preferably heated gas.

The heating unit 76 has a plurality of lamps 76A, and is arranged above the table 73. When each lamp 76A is turned on, it irradiates the surface of the substrate W on the table 73 with light. A moving mechanism 76B can vertically (in an elevating direction) move the heating unit 76 between a irradiation position close to the cup 72 (i.e., a position near the surface of the substrate W as indicated by the solid line in FIG. 5) and a standby position spaced from the cup 72 by a predetermined distance (i.e., a position spaced from the surface of the substrate W as indicated by alternate long and short dash line in FIG. 5). When the substrate W is to be set on the table 73 in the substrate drying chamber 70, the heating unit 76 is located in the standby position so that the heating unit 76 can be prevented from impeding the carrying-in of the substrate W. The heating unit 76 can be lowered after or before the turn-on of the lamp. The heating unit 76 is electrically connected to the controller 80, which controls the driving thereof.

The heating unit 76 may be formed of the plurality of lamps 76A, e.g., of a straight-tube type arranged in parallel, or the plurality of lamps 76A of a light ball type arranged in an array fashion. The lamp 76A may be, for example, a halogen lamp, xenon flash lamp or the like.

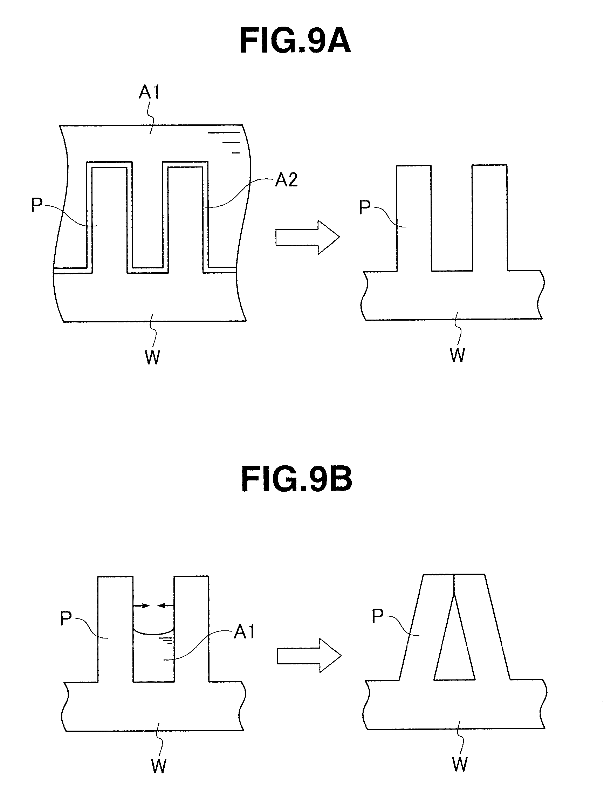

In heating of the substrate W using the heating unit 76, as illustrated in FIG. 9A, the heating by the heating unit 76 causes liquid A1 of the volatile solvent in contact with a pattern P on the surface of the substrate W to start evaporation earlier than the liquid A1 of the volatile solvent on the other portion. More specifically, in the liquid A1 of the volatile solvent supplied to the surface of the substrate W, only the liquid in contact with the surface of the substrate W is rapidly heated to attain the gas phase. Thereby, gasification (boiling) of the liquid A1 of the volatile solvent forms a gas layer (collection of bubbles), namely a gas layer A2 of the volatile solvent taking a thin-film-like form around the pattern P on the surface of the substrate W. Therefore, the liquid A1 of the volatile solvent between the neighboring patterns P is pushed onto the surface of the substrate W by the gas layer A2, and its own surface tension changes the liquid A1 into many droplets. FIG. 9B illustrates a phenomenon in which, during drying of the liquid, various portions of the substrate surface are dried at uneven drying speeds so that the liquid A1 may be left between some patterns P, and the surface tension of the liquid A1 thus left collapses the pattern.

The suction drying unit 77 is substantially the same as the solvent suction discharging unit 55 in the substrate cleaning chamber 50. For the operation, it is set in the operation position where a solvent suction port 77A having an annular opening directed to the periphery of the table 73 is positioned around the substrate W held by the table 73. The solvent suction port 77A absorbs and receives the volatile solvent dispersed from the rotating substrate W. The suction drying unit 77 is electrically connected to the controller 80, which controls the operation thereof. The solvent suction port 77A is connected to a vacuum pump (not illustrated) for absorbing liquid droplets of the volatile solvent as well as a discharge pipe (not illustrated) for discharging the droplets of the volatile solvents thus absorbed and received.

The controller 80 includes a microcomputer centrally controlling various portions, and a storage storing the substrate processing information and various programs relating to the substrate processing. The controller 80 controls the rotation mechanism 74, gas supply unit 75, heating unit 76, suction drying unit 77 and others based on the substrate processing information and the various programs, and further controls gas supply by the gas supply unit 75, heating by the heating unit 76, suction by the suction drying unit 77, and others effected on the surface of the substrate W on the rotating table 73.

Procedures of cleaning and drying the substrate W by the substrate processing device 10 will now be described below.
(1) The transporting robot 11 supplies the substrate W from the substrate storing cassette 21 of the substrate supply/discharge unit 20 to the in-dedicated buffer 31 of the substrate storing buffer unit 30, and the transporting robot 12 takes out and sets the supplied substrate W on the table 53 of the substrate cleaning chamber 50 in the substrate processing chamber 40. In this state, the controller 60 of the substrate cleaning chamber 50 controls the rotation mechanism 54 to rotate the table 53 at a predetermined rotation speed, and then controls the chemical solution supply unit 56 while positioning the solvent suction discharging unit 55 in the standby position so that the chemical solution, i.e., APM is supplied from the nozzle 56A to the surface of the substrate W on the rotating table 53 for a predetermined time. The chemical solution, i.e., APM is discharged from the nozzle 56A toward the center of the substrate W on the rotating table 53, and the centrifugal force caused by the rotation of the substrate W spreads it over the whole surface of the substrate W. Thereby, the APM covers and processes the surface of the substrate W on the table 53.

The controller 60 continuously rotates the table 53 for a period from the above (1) to (3) to be described later. In this operation, the processing conditions such as a rotation speed of the table 53, a predetermined time and the like are set in advance, but an operator can arbitrarily change them.
(2) After stopping the supply of the chemical solution, the controller 60 then controls the cleaning liquid supply unit 57 to supply the cleaning liquid, i.e., ultrapure water from the nozzle 57A to the surface of the substrate W on the rotating table 53 for a predetermined time. The cleaning liquid, i.e., ultrapure water is discharged from the nozzle 57A toward the center of the substrate W on the rotating table 53, and is spread over the whole surface of the substrate W by the centrifugal force caused by rotation of the substrate W. Thereby, the surface of the substrate W on the table 53 is covered and cleaned by the ultrapure water.

(3) After the supply of the cleaning liquid by the cleaning liquid supply unit 57 stopped, the controller 60 then locates the solvent suction discharging unit 55 in the operation position, and controls the solvent supply unit 58 to supply the volatile solvent, i.e., IPA from the nozzle 58A to the surface of the substrate W on the rotating table 53 for a predetermined time. The volatile solvent, i.e., IPA is discharged from the nozzle 58A toward the center of the substrate W on the rotating table 53, and is spread over the whole surface of the substrate W by the centrifugal force caused by rotation of the substrate W. At this time, the solvent suction discharging unit 55 absorbs the IPA dispersing from the rotating substrate W. Thereby, the ultrapure water on the surface of the substrate W on the table 53 is replaced with the IPA. The rotation speed of the substrate W, i.e., the table 53 in the above operation is substantially set such that a film of the volatile solvent formed over the surface of the substrate W is thin to an extent that the surface of the substrate W is not exposed.

The IPA discharged from the nozzle 58A of the solvent supply unit 58 is set to a temperature below a boiling point so that the IPA may be reliably in the liquid state when it is supplied to the surface of the substrate W, and thereby the ultrapure water may be reliably and uniformly replaced with the IPA on the whole surface of the substrate W. In this embodiment, the IPA in the liquid state is continuously supplied to the substrate W.

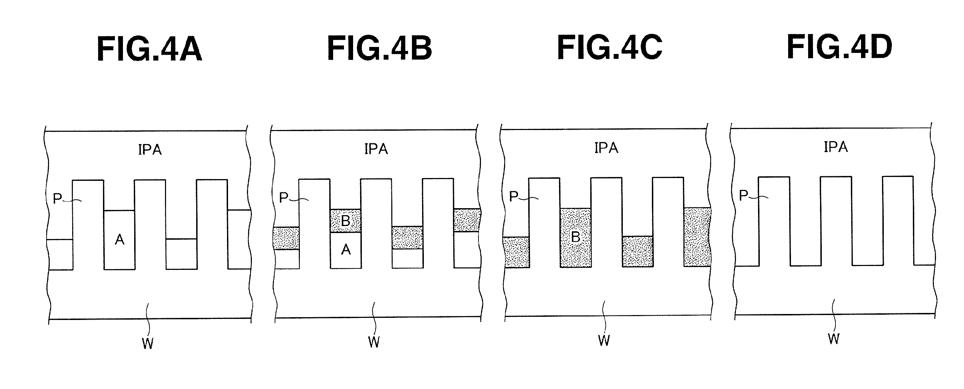

After the controller 60 starts discharging of the IPA through the nozzle 58A of the solvent supply unit 58 to the surface of the substrate W, it positions the upper magnet 101 of the magnetic field forming unit 100 in the operation position to apply the magnetic field produced between the upper and lower magnets 101 and 102 to the surface of the substrate W. Thereby, the cleaning liquid already supplied from the cleaning liquid supply unit 57 onto the surface of the substrate W is stirred and mixed with the volatile solvent as described in the following (i) - (iii) by the Moses effect caused by the magnetic field forming unit 100, so that the replacement of the cleaning liquid with the volatile solvent is promoted (FIGS. 4A to 4D). In FIGS. 4A and 4B, "A" indicates water, and "B" indicates a mixture liquid of the water and the IPA.

When the substrate W is set on the table 53 of the substrate cleaning chamber 50, the upper magnet 101 of the magnetic field forming unit 100 is positioned in the standby position. Thereby, the upper magnet 101 does not impede the carrying-in of the substrate W, and further it is possible to prevent adhesion of the chemical solution to the upper magnet 101. The upper magnet 101 may be positioned in the operation position before the nozzle 58A of the solvent supply unit 58 starts discharging of the IPA to the surface of the substrate W.
i. In an initial stage of supply of the IPA by the solvent supply unit 58, the water is adhered to the inside of the pattern gap of the substrate W, and the IPA supplied over the water is not mixed with the water and is separated from it (FIG. 4A).

ii. The Moses effect produced by the magnetic field formed by the upper and lower magnets 101 and 102 of the magnetic field forming unit 100 stirs the water on the surface of the substrate W to cause vibration as described before. Thereby, mixing of the water and the IPA gradually starts (FIG. 4B), and all the water adhering to the whole area of the inside of the pattern gap of the substrate W will be mixed with the IPA (FIG. 4C).

iii. Under the formation of the magnetic field in the above (ii) by the magnetic field forming unit 100, the solvent supply unit 58 continues the supply of the new IPA while the rotation of the table 53 is spinning off and removing the liquid from the surface of the substrate W by a centrifugal force. Thereby, in the liquid mixture of the water and the IPA spreading throughout the inside of the pattern gap of the substrate W in the above (ii), the IPA concentration gradually increases owing to supply of the new IPA, and consequently the replacement with the IPA reliably takes place throughout the surface of the substrate W (FIG. 4D).

After the supply of the IPA ends, the controller 60 positions the upper magnet 101 of the magnetic field forming unit 100 in the standby position. Thereby, the upper magnet 101 of the magnetic field forming unit 100 will not impede the removal of the substrate W in the following item (4). While the IPA is still being supplied to the substrate W in a final stage of the IPA replacement processing, the upper magnet 101 may be positioned in the standby position. In this case, the upper magnet 101 is already positioned in the standby position when the IPA replacement processing ends. Therefore, the removable of the substrate W can be started without a waiting time due to transporting of the upper magnet 101, and the working efficiency can be high.
(4) Then, the controller 60 stops rotation of the table 53 of the substrate cleaning chamber 50, and the transporting robot 12 takes out the substrate W on the rotation-stopped table 53 from the substrate cleaning chamber 50, and the substrate W is set on the table 73 of the substrate drying chamber 70 in the substrate processing chamber 40. The controller 80 of the substrate drying chamber 70 controls the gas supply unit 75 to supply the gas, i.e., nitrogen gas from the nozzle to the surface of the substrate W on the rotating table 73 for a predetermined time. The nozzle 75A discharges the nitrogen gas toward the whole area of the substrate W on the table 73. Thereby, the nitrogen atmosphere is formed in the space containing the substrate W on the table 73. By keeping the nitrogen atmosphere in this space, the oxygen concentration is reduced to suppress generation of watermarks on the surface of the substrate W.

The controller 80 continuously rotates the table 73 from the above (4) to (6) to be described later. For this, the processing conditions such as the rotation speed of the table 73 and the predetermined time are preset, but an operator can arbitrarily change them.
(5) Then, the controller 80 controls the heating unit 76 to turn on each lamp 74A of the heating unit 76 to move the heating unit 76 in the standby position to the irradiation position, to heat the substrate W on the rotating table 73 for a predetermined time. At this time, the heating unit 76 can perform the heating that can raise the temperature of the substrate W to 100 degrees C or above in 10 seconds. This can instantaneously vaporize the liquid A1 of the volatile solvent in contact with the pattern P on the surface of the substrate W, and can immediately form the droplets of the liquid A1 of the volatile solvent on the other portion of the surface of the substrate W.

In the above heat drying by the heating unit 76, it is important to heat the substrate W to a high temperature of hundreds of degrees C within several seconds for instantaneously evaporating the volatile solvent, i.e., IPA in contact with the pattern P of the substrate W. It is necessary to heat only the substrate W without heating the IPA. For this, it is desirable to use the lamp 76A having a peak intensity in wavelengths of 500 - 3000 nm. For reliable drying, it is desirable that the final temperature of the substrate W attained by the heating is higher than the boiling points of the processing liquid and the solvent at an atmospheric pressure by 20 degrees C or more. Additionally, it is desirable that the time required for reaching the final temperature is substantially within 10 seconds and, for example, falls within a range from several tens of milliseconds to several seconds.
(6) The liquid droplets of the IPA produced on the surface of the substrate W by the heating operation of the heating unit 76 are dispersed radially outward by the centrifugal force caused by the rotation of the substrate W, and reach the suction drying unit 77. In this operation, the solvent suction port 77A has a suction force so that the liquid droplets of the IPA that reached the suction drying unit 77 are absorbed and removed through the solvent suction port 77A. Thereby, the drying ends. In this embodiment, therefore, the table 73, the rotation mechanism 74, the suction drying unit 77 and others form the drying unit drying the surface of the substrate by removing the droplets of the volatile solvent that were produced on the surface of the substrate by the heating operation of the heating unit 76.

(7) Then, the controller 80 stops the rotation of the table 73. The transporting robot 12 takes out the substrate W already dried on the rotation-stopped table 73 from the substrate drying chamber 70, and brings the substrate W into the out-dedicated buffer 32 of the substrate storing buffer unit 30. When the out-dedicated buffer 32 is internally provided with the cooling unit as described before, this cooling unit forcedly cools the substrate W.

Before taking out the substrate W in the above (7), the controller 80 turns off the lamp 76A of the heating unit 76, and locates it in the standby position. Thereby, the heating unit 76 does not impede the removal of the substrate W.
(8) The transporting robot 11 takes out the substrate W from the out-dedicated buffer 32 of the substrate storing buffer unit 30, and discharges it to the substrate storing cassette 21 of the substrate supply/discharge unit 20.

Thus, in the substrate processing device 10, the substrate processing chamber 40 has the substrate cleaning chamber 50 and the substrate drying chamber 70, and the transporting robot 12 serving as the substrate transporting unit is arranged between the substrate cleaning chamber 50 and the substrate drying chamber 70. Thereby, the step of supplying the cleaning liquid to the surface of the substrate W as well as the step of supplying the volatile solvent to the surface of the substrate W supplied with the cleaning liquid and promoting the replacement of the cleaning liquid on the surface of the substrate W with the volatile solvent by the magnetic field forming unit 100 are performed in the substrate cleaning chamber 50. The substrate W supplied with the volatile solvent in the substrate cleaning chamber 50 is transferred by the transporting robot 12 to the substrate drying chamber 70. In the substrate drying chamber 70, the step of heating the substrate W supplied with the volatile solvent in the substrate cleaning chamber 50 as well as the step of removing the droplets of the volatile solvent produced on the surface of the substrate W by the heating of the substrate W to dry the surface of the substrate W are performed.

This embodiment achieves the following operations and effects.

When the solvent supply unit 58 supplies the IPA to the surface of the substrate W after the cleaning liquid supply unit 57 supplied the cleaning liquid to the surface of the substrate W, the magnetic field forming unit 100 applies the magnetic field to the surface of the substrate W on which both the cleaning liquid and the IPA are present, and thereby stirs the cleaning liquid and the volatile solvent on the surface of the substrate W to mix them together. The stirring and mixing of the cleaning liquid and the volatile solvent by the Moses effect are applied throughout the interior of the pattern gap of the substrate W, and the whole water that has entered throughout the interior of the patter gap of the substrate W can be effectively mixed with the IPA. Thereby, the cleaning liquid existing in the pattern gap of the substrate W can be reliably replaced with the IPA having the low surface tension, and the pattern collapse can be effectively prevented during drying of the substrate W.

Owing to the Moses effect by the magnetic field forming unit 100, the cleaning liquid on the surface of the substrate W can be efficiently replaced with a relatively small amount of volatile solvent supplied thereto, and the amount of the volatile solvent to be used can be reduced. Further, the volatile solvent can be efficiently fed into the pattern gap of the substrate W, and the execution time of the cleaning and replacing step can be reduced. This can improve the productivity of the substrates W.

The magnetic field forming unit 100 is formed of the pair of the upper and lower magnets 101 and 102 arranged in the two positions on the front and rear sides of the substrate W, respectively. Thereby, the magnetic flux produced between the upper and lower magnets 101 and 102 can be dense to apply a strong magnetic field to the surface of the substrate W, and this can improve the efficiency of stirring and mixing the cleaning liquid and the volatile solvent on the surface of the substrate W.

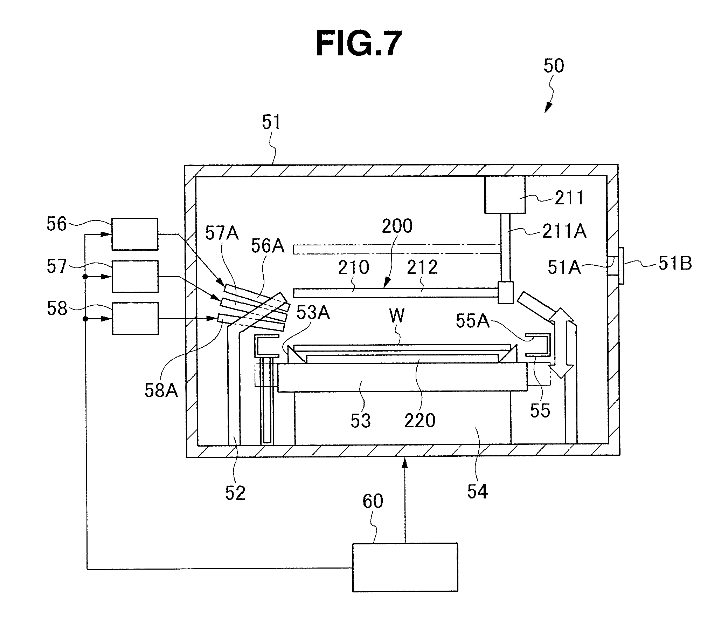

FIG. 7 illustrates a modification in which the magnetic field forming unit 100 added to the solvent supply unit 58 in FIG. 2 is replaced with a magnetic field forming unit 200. The magnetic field forming unit 200 is formed of a pair of upper and lower magnets 210 and 220 arranged on the front and rear sides of the substrate W held on the table 53, respectively.

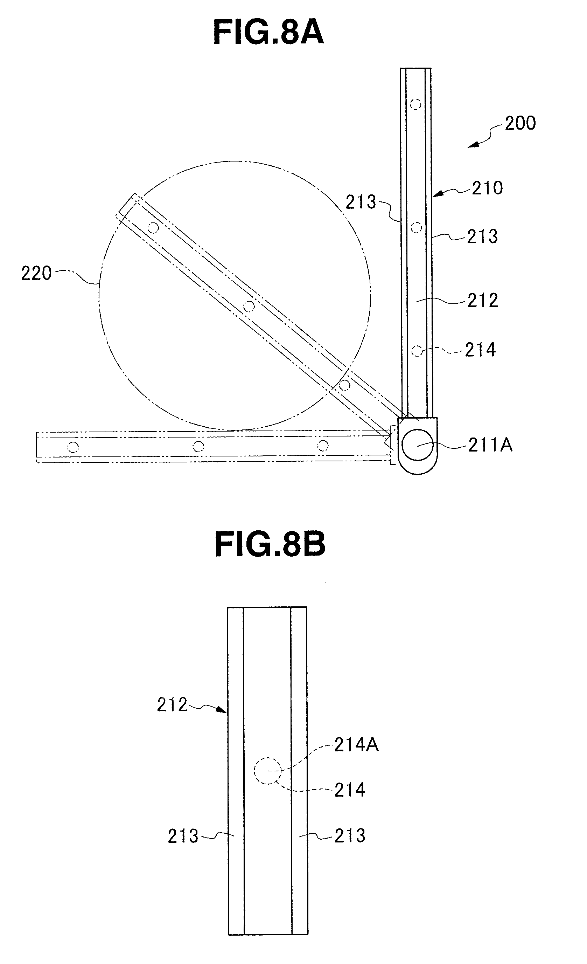

As illustrated in FIGS. 7, 8A and 8B, the upper magnet 210 includes a swing arm 212 and an elevating and swinging unit 211 elevating and swinging the swing arm 212. The elevating and swinging unit 211 is arranged on the ceiling surface of the processing box 51. In a plan view, a swing shaft 211A for elevating and swinging the swing arm 212 is arranged outside the substrate W held on the table 53. The elevating and swinging unit 211 elevates the swing arm 212 fixedly supported by the lower end of the swing shaft 211A to position it selectively in a standby position (indicated by alternate long and short dash line in FIG. 7) spaced from the surface of the substrate W and an operation position (indicated by solid line in FIG. 7) close to the surface of the substrate W, and further can horizontally swing the swing arm 212 relatively to the surface of the substrate W.

The upper magnet 210 includes rod magnets 213 arranged at the opposite side portions of the swing arm 212 through its whole length, respectively, and is provided with nozzles 214A of a solvent supply unit 214 at a plurality of positions of a middle portion along the longitudinal direction instead of the nozzle 58A of the solvent supply unit 58, respectively. The substrate cleaning chamber 50 to which the magnetic field forming unit 200 is applied may employ the nozzle 58A of the solvent supply unit 58 together with the nozzles 214A of the solvent supply unit 214. Also, the nozzle 58A of the solvent supply unit 58 may be eliminated.

The lower magnet 220 is fixed to the upper surface of the table 53, and has a circular disk-like form rotating together with the table 53.

The magnetic field forming unit 200 causes the upper magnet 210 to perform horizontal swinging (including reciprocative swinging) while positioning it in the operation position, discharges the IPA through the nozzle 214A of the solvent supply unit 214 to the surface of the substrate W, and applies the magnetic field occurring between the upper and lower magnets 210 and 220 to the surface of the substrate W. Thereby, the cleaning liquid on the surface of the substrate W which is already supplied from the cleaning liquid supply unit 57 is stirred and mixed with the volatile solvent owing to the Moses effect similarly to that in the magnetic field forming unit 100, so that the replacement of the cleaning liquid with the volatile solvent is promoted.

The magnetic field forming unit 200 of the embodiment achieves the following operation and effect in addition to those of the magnetic field forming unit 100 already described. Since the magnetic field forming unit 200 forms the magnetic field by the horizontally swing of the upper magnet 210 in addition to the rotation of the lower magnet 220, it dynamically changes the magnetic field applied to the surface of the substrate W, and therefore can stir the cleaning liquid on the surface of the substrate W to mix it with the volatile solvent to a higher extent.

The magnetic field forming unit 200 includes the magnets 213 and the solvent supply unit 214 at the swing arm 212 of the upper magnet 210, and simultaneously performs the supplying of the volatile solvent to the various portions of the surface of the substrate W and the formation of the magnetic field. Thereby, it can promote the replacement while uniformizing the degree of stirring and mixing of the cleaning liquid and the volatile solvent.

Although the invention has been described in detail with reference to the drawings, the specific structure of the invention is not restricted to these embodiments, and the invention contains changes and variations of design within a scope not departing from the essence of the invention.

For example, each of the magnets forming the magnetic field forming units 100 and 200 may be a permanent magnet such as a neodymium magnet, an electromagnet, or a superconducting magnet. When the electromagnet is used, intensities of the respective magnetic fields applied to various portions (such as a central portion and peripheral portions) of the surface of the substrate W are adjusted to apply a stronger magnetic field to a portion (e.g., an outer peripheral portion of the substrate W) on the surface of the substrate W where a replaceability of the cleaning liquid with the volatile solvent is low. This can uniformize the degree of stirring and mixing of the cleaning liquid and the volatile solvent at the various portions of the surface of the substrate W. The intensity of the magnetic field may be changed by changing the lowered position of the upper magnet 101 or 210, i.e., the distance to the substrate surface. When the upper magnet 101 or 210 is located closer to the substrate surface, the intensity of the magnetic field increases, and vice versa.

For example, the magnetic field forming unit 200 may be configured to change the swinging speed of the swing arm 212, for example, such that the swinging speed of the swing arm 212 relatively decreases when the swing arm 212 is opposed to a surface portion of the substrate W where the replaceability of the cleaning liquid with the volatile solvent is low.

When the upper and lower magnets of the magnetic field forming units 100 and 200 are made of the electromagnets, respectively, the directions of the power supply to the electromagnets may be inverted with time, and the up-down direction of the magnetic flux applied to the cleaning liquid and the volatile solvent on the surface of the substrate W may be inverted with time. Thereby, the force of the magnetic field applied to the water between the patterns on the surface of the substrate changes, and this change in force vibrates and thereby stirs the water between the patterns, resulting in further improvement of the stirring and mixing efficiency of the cleaning liquid and the volatile solvent.

The operation of supplying the inert gas such as nitrogen gas by the gas supply unit 75 is configured to start after the substrate W is set in the substrate drying chamber 70, but the operation may start before it is set.

For example, in each Embodiment, the heating of the substrate W by the heating unit 76 may be performed in a state where the pressure in the processing box 71 is reduced. This lowers the boiling point of the volatile solvent such as IPA in the processing box 71, and causes boiling at a temperature lower than that in the atmospheric pressure so that the heat damage to the substrate can be reduced.

In each embodiment, the supply of the volatile solvent such as IPA to the substrate W starts after the supply of the cleaning liquid to the substrate W stops. However, the supply of the volatile solvent may start while the supply of the cleaning liquid to the substrate W still continues in a final period of the cleaning with the cleaning liquid.

Prior to the supply of the volatile solvent such as IPA to the substrate W, an atmosphere of inert gas such as nitrogen gas may be kept in the processing box 51.

The invention reliably replaces the cleaning liquid on the substrate surface with the volatile solvent, and thereby can effectively prevent the pattern collapse at the time of substrate drying.

### [Industrial Applicability]

### [Explanations of letters of numerals]

- 10: substrate processing device
- 50: substrate cleaning chamber
- 57: cleaning liquid supply unit
- 58: solvent supply unit
- 70: substrate drying chamber
- 76: heating unit
- 77: suction drying unit (drying unit)
- 100: magnetic field forming unit
- 101: upper magnet
- 102: lower magnet
- 200: magnetic field forming unit
- 210: upper magnet
- 212: swing arm
- 214: solvent supply unit
- 214A: nozzle
- 220: lower magnet
- W: substrate

## Claims

1. A substrate processing device (10) comprising:
a cleaning liquid supply unit (57) supplying a cleaning liquid to a surface of a substrate (W);
a solvent supply unit (58, 214) supplying a volatile solvent to the surface of the substrate (W) supplied with the cleaning liquid, and replacing the cleaning liquid on the surface of the substrate (W) with the volatile solvent; and
a heating and drying unit (76, 77) heating the surface of the substrate (W) supplied with the volatile solvent to dry the surface of the substrate (W) by removing droplets of the volatile solvent produced on the surface of the substrate (W) by a heating operation, wherein
the substrate processing device (10) further comprises a magnetic field forming unit (100, 200) applying a magnetic field to the surface of the substrate (W) on which the cleaning liquid and the volatile solvent coexist to promote the replacement of the cleaning liquid with the volatile solvent.

2. The substrate processing device according to claim 1, wherein
the magnetic field forming unit (100, 200) is formed of a pair of magnets (101, 102; 210, 220)) arranged on two positions on a front side and a rear side of the substrate (W), respectively.

3. The substrate processing device according to claim 1 or 2, wherein
the magnetic field forming unit (200) is arranged in an arm (212) being relatively movable with respect to the surface of the substrate (W), the arm (212) includes a supply nozzle (214A) of the volatile solvent, and supply of the volatile solvent to the surface of the substrate (W) and formation of the magnetic field are simultaneously performed.

4. A substrate processing method comprising the steps of:
supplying a cleaning liquid to a surface of a substrate (W);
supplying a volatile solvent to the surface of the substrate (W) supplied with the cleaning liquid, and replacing the cleaning liquid on the surface of the substrate (W) with the volatile solvent; and
heating the surface of the substrate (W) supplied with the volatile solvent to dry the surface of the substrate (W) by removing droplets of the volatile solvent produced on the surface of the substrate (W) by a heating operation, wherein
a magnetic field is applied by a magnetic field forming unit (100, 200) to the surface of the substrate (W) on which the cleaning liquid and the volatile solvent coexist to promote the replacement of the cleaning liquid with the volatile solvent.

5. The substrate processing method according to claim 4, wherein
the magnetic field forming unit (100, 200) is formed of a pair of magnets (101, 102; 210, 220) arranged on two positions on a front side and a rear side of the substrate (W), respectively.

6. The substrate processing device according to claim 4 or 5, wherein
the magnetic field forming unit (200) is arranged in an arm (212) being relatively movable with respect to the surface of the substrate (W), the arm (212) includes a supply nozzle (214A) of the volatile solvent, and supply of the volatile solvent to the surface of the substrate (W) and formation of the magnetic field are simultaneously performed.
